# EUROPEAN PATENT APPLICATION

(11) **EP 1 826 292 A1**
(43) Date of publication of application: **29.08.2007**
(21) Application number: 06110318.0
(22) Date of filing: 23.02.2006
(51) Int. Cl.: C23C 14/56

(54) **Sputter module.**

(71) Applicant: Bekaert Advanced Coatings, 9800 Deinze (BE)
(72) Inventor: Van de Putte, Ivan, 8800 Roeselare (BE); De Bosscher, Wilmert, 9031 Drongen (BE)
(74) Representative: Messely, Marc

(57) **Abstract**

Large area coating lines cannot easily be reconfigured to deposit other types of coating stacks as the ones they were designed for. One of the reasons for this is the interaction that occurs between pumping process and the sputtering process. The latter differs strongly as to what type of materials are deposited (metals or compounds) and as to whether this deposition is performed in a reactive or an inert atmosphere. A careful matching of sputtering and pumping is needed for each new layer stack that is to be produced on the line. This matching process can be greatly reduced by spatially fixing the pumping and sputtering processes to one another as in the disclosed inventive module. The module integrates the pumping with the sputtering and thereby largely matches pumping and sputtering to one another. Various advantageous embodiments are described.

## Description

### Field of the invention.

The sputtering modules, the subject of the invention described in what follows, are mounted on sections of line coaters that are e.g. used to coat large area glass panes by means of sputtering in a controlled low-pressure atmosphere.

### Background of the invention.

Taylor-made surface stacks can entail many advantageous functionalities to those goods that are usually sold per unit of area. Such a stack may comprise different layers and it is necessary that each layer is uniform in thickness and composition. One application where this uniformity requirement is particularly stringent is the coating of transparent objects such as windowpanes or plastic film. Indeed, unlike the painting of a wall where variations in the thickness are not visible to the naked eye due to the opacity of the paint (provided of course a minimum thickness has been applied), the coating of glass or transparent articles in general is unforgiving to thickness variations as they immediately are discernable as irregularities in the transparency of the article. Moreover, as the layers are many times formed by a reaction occurring at the solid/gas interface, the relative proportion of the constituents must be particularly uniform.

Such functional glass coatings are applied in large area glass coaters where - under a low pressure atmosphere of a noble gas (notably argon) or a mixture of a noble gas and a reactive gas (oxygen, nitrogen to name the most common) - material from an elongated material source called 'target' is transferred to the glass pane by means of a sputtering process. In such a sputtering process, the gas atoms are ionised and impinge onto the target under the influence of a negative potential maintained at the target surface. Atoms or groups of atoms at the surface of the target are ejected around, many of them hitting the glass substrate. The efficiency of the process can be improved by confining the electrons of the plasma in a magnetic racetrack. The racetrack is generated by permanent magnets positioned opposite to the sputtered surface.

The coating of glass panes is sequentially performed in long installations starting with a loading section and ending with a discharge section. In between sputtering sections and evacuation sections alternate one after the other because functional stacks many times comprise different layers of various dielectric compounds possibly alternated with metal layers. So different gas atmospheres have to be maintained in different sputter sections. The evacuation sections are introduced for two reasons. Firstly they can provide a base pumping capacity for pumping down the whole system and keeping it at low pressure what is called 'process pumping'. Secondly they can be introduced as gas separation means to allow two different gas atmospheres at either side of the evacuation section sometimes referred to as 'isolation pumping'. In the end one arrives at long installations having a series of evacuation sections where in between one or more sputter sections are arranged as dictated by the deposition speed of each sputter section (that can differ widely from substance to substance) as all the glass panes move at the same speed.

The way in which gasses are pumped out of the sputtering section is crucial for the uniformity of the coating. Indeed, the uniformity of the sputtering behaviour over the length of the racetrack is to a great extent determined by the uniformity of the gas partial pressure in the sputter section. The plasma density is amongst others determined by the total local gas pressure and the ratio of partial local gas pressures in case a mixture of gasses is admitted. Indeed while for a pure gas the possibility of ionisation is depending on the properties of only one gas, for a mixture this is different as both gasses have a different ionisation cross section, sputter behaviour and reactivity with the deposited coating. The admission of gas can be well controlled by using dedicated, elongated gas distribution systems (such as described in PCT/EP2005/054986) that are mounted on the module that also carries the targets. Such modules have standardised mounting flanges, making quick exchange of modules possible for replacing used targets or for changing the coating layer. Hence, such a module always provides the same gas flow relative to the sputtering target without tedious adjustment. Contrary to that, the evacuation of gas remains more difficult due to a number of reasons as will be explained below.

Firstly, many coating lines have dedicated diffusion pumps per section. Depending on the section, one or more target modules can be accommodated. Diffusion pumps only work when the pump is suspended from the section as the pump oil collects in the sump at the bottom of the pump. Alternatively, dedicated turbomolecular pumps per section can be used (an example being disclosed in DE 197 33 940 A1). Such pumps can be mounted in virtually every direction. Such lines are relatively inflexible, as the pumping sections cannot easily be changed. Hence, changing the coating stack involves rather elaborate adjustments of process parameters before the desired stack is obtained.

As a solution to that compartment coaters have been devised. In a compartment coater, all sections are substantially identical and have one or two standard openings wherein either a sputter module or a pump module (either only for process pumping or for gas separation) fits. As the openings are normally at the top of the modules, turbo molecular pumps are mounted in an upright position on top of the flanges. With some adaptations, diffusion pumps can also be used (US 2005/0223995 A1). The modules can easily be swapped in order to reconfigure the line by means of overhead cranes. The gas flow regime in a sputter section is then determined by the plenum attached to the pump module is introduced into the compartment and separates sputter sections from one another. The plenum has several pump openings in it. Depending on the orientation, the number and shape of these openings and the positioning of the pumps on the pump module different gas flows are obtained. Again tedious test runs with incremental adjustments become necessary in order to obtain the right layer in the stack.

Due to the above-cited problems of non-standardised evacuation systems, it is not possible to develop a 'fit-for-all' sputtering module due to these installation dependent pumping characteristics. The inventors therefore set themselves the task to solve this problem.

### Summary of the invention.

The primary object of the invention is to provide a module that can be mounted on any installation without the need of extensive adjustments. The object of the invention is therefore to provide a module wherein all process influencing physical factors such as target position, gas distribution and pumping have a fixed spatial relationship to one another independent of the installation in which they are put. It is a further object of the invention to provide also the control means to steer these physical factors in the same module.

According a first aspect of the invention a sputtering module is disclosed (claim 1). Such a module comprises an interface flange of substantially rectangular shape that provides the platform on which the other parts are mounted. The flange is foreseen with the necessary sealing means (e.g. gaskets) to allow a vacuum tight seal to the compartment on which it is mounted. So an atmospheric side and a vacuum side can be identified. At the vacuum side, at least one pair of end-blocks (with 'one pair' is to be understood one left and one right end-block), are vacuum tight mountable. Such end-blocks carry the target inside the compartment and provide it with at least electrical current and cooling. The module is distinct from the prior-art in that vacuum pumps are mounted at the atmospheric side of the interface flange. The pumps are mounted on evacuation openings made in the interface flange. As the pump openings are mounted on the same flange as the end-blocks - and thus the targets it can carry - a fixed spatial relationship always exists between the evacuation openings and the targets. In this way the problem of varying evacuation flows from coating line to coating line can be solved. Another bonus of the inventive module is that it allows designing shorter installations as some of the process pumping capacity is integrated in the sputtering module thereby reducing the number of pumping modules. On existing installations, some pumping modules can be replaced with modules according the invention, thereby increasing the flexibility of the line or the throughput of the line or both.

Sputter targets can come in a variety of forms such as planar targets or rotatable targets. The latter are more preferred (claim 2) as they carry a larger stock of material, allow for a better total usage of the material and enable a more stable process. On the other hand the end-blocks must now also be able to transfer motion and to maintain vacuum integrity, which makes them somewhat more complex.

The module can further be provided with a diverter that is mountable on the vacuum side of the flange between the openings and the target (claim 3). Such a diverter serves to equalise the gas exit flow over the entire length of the target. In its most simple form such a diverter can be a plate mounted preferably between 5 and 150 mm from the flange that is made from a material that does not degas and is temperature resistant. A metal or metal alloy plate is well fit to do the job. The shape of the plate is chosen in function of the gas flow that exists from the compartment to the pumps. Preferably it extends somewhat over the width of the targets and has bend edges. The shape and distance to the flange of the diverter can be optimised by a computational fluid dynamics simulation software such as FLUENT, a package from Fluent, Sweden. In another embodiment the diverter can also be extended so as to form an inverted U-shape, the legs ending just above the passing substrates so as to provide a local gas atmosphere inside the diverter. In still another embodiment the diverter may be a long rectangular box-like construction, positioned between the flange and the targets. The box is provided with on the one hand holes that are connectable to the pump openings and on the other hand with holes that connect to the evacuable compartment. In order to adapt the target-to-substrate distance or the flange-to-target distance or both, extension pieces can be mounted between the flange and the end-block or a vacuum-tight spacer flange can be put between the mounting flange and the compartment.

It is not excluded that said diverter is electrically biased with respect to the target as to influence the plasma and the deposition. As the diverter forms one single unit with the sputtering targets and evacuation pumps, the outflow of gasses is fixed and no - or at least a very limited - further optimisation of sputtering parameters is needed.

The diverter can be mounted adjustable relative to the flange on which it is mounted. Such adjustment can be done by means of adjusting screws or rods as commonly known in the art (claim 4). In this way the pumping rate can be adjusted laterally along the targets i.e. perpendicular to the substrate movement direction. Preferably this adjustment is performed from the atmospheric side, for example by means of properly sealed moveable adjustment rods protruding through the mounting flange (claim 5).

For proper control of the gas feeding, a gas distribution system such as e.g. disclosed in PCT/EP2005/054986 is mounted between the diverter and the targets. The diverter thereby prevents that gas fed into the compartment is immediately sucked out of the system (claim 6).

The mounting flange is used as the base of a housing wherein - next to the vacuum pumps - the gas feeding means (comprising e.g. mass flow controllers, gas mixers, tubing, valves and the like), the coolant feeding means (normally water tubing), the electricity feeding means (high voltage, high current leads, current conditioning means like electric filters and related apparatus), the target movement or target rotation means (targets are usually driven by an electric motor) or control means (e.g. to check seal integrity, current condition, coolant temperature to name just a few) are incorporated.

By preference the housing is provided with eyelets to lift the module by means of a crane. The module is therefore mainly used in a position where the flange is substantially horizontal (claim 8).

According a second aspect of the invention, a coating line is claimed where on at least one of the compartments the above described inventive module is mounted (claim 9).

### Brief description of the drawings.

The invention will now be described into more detail with reference to the accompanying drawings wherein
- FIGURE 1 shows an overall view of the module as mounted on a compartment.
- FIGURE 2 shows a perspective view of the module
- FIGURE 3 shows a cross section of the module perpendicular to the direction of the target.

### Description of the preferred embodiments of the invention.

In the drawings, the last two digits refer to identical pieces, the first one to the number of the figure.

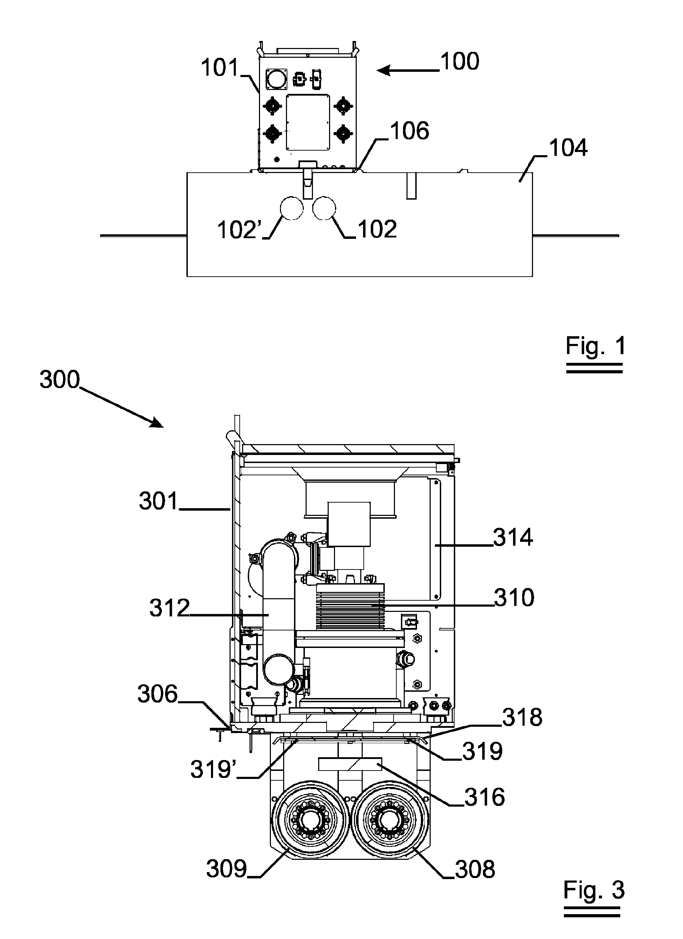

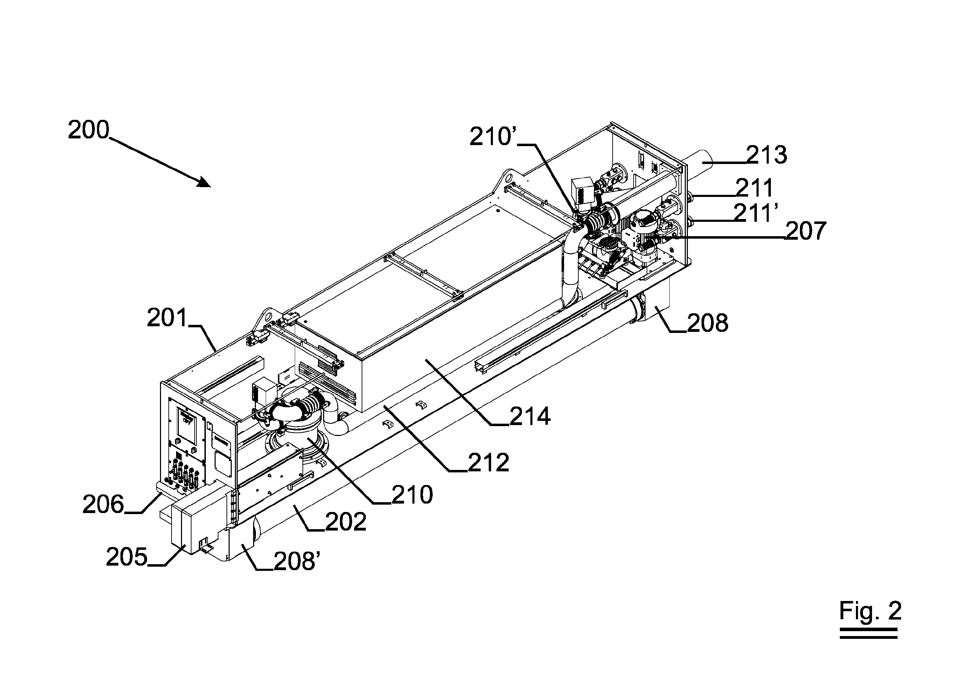

FIGURE 1 is a schematic view of how a module 100 for coating a large area glass pane is mounted on an evacuable compartment 104. The module is mounted on the compartment by means of an interface flange 106 that provides for a vacuum-tight seal to the compartment. On the mounting flange 106 a housing 101 is fixed foreseen with eyes for lifting up the whole module by means of a crane. Control electronics are present in the box 214. Below the module, two targets 102, 102' are mounted. Each target is carried by two end-blocks 208,208' mounted to the vacuum side of the flange 206 as depicted in FIGURE 2. Another pair of end-blocks of which one 309 is visible in FIGURE 3 is mounted alongside. The targets are rotatable targets that are fed with electric current through connector housing 205, cooled with coolant fed through 211, 211' and are rotated by an electric motor 207 (one motor for each target). Gas supplies (not visible) are provided next to the electric connector housing 205.

Inside the housing 201 at the atmospheric side of the flange, two turbomolecular pumps 210, 210' are mounted that pump the compartment through openings (not visible). The turbomolecular pumps are prepumped through evacuation line 212 by roughing pumps (e.g. booster pumps, not shown) connected to outlet 213. A diverter 318 is mounted between the targets 202, 202' and the mounting flange 306. Spacers 319, 319' maintain a distance between the openings and the diverter. Although not provided in this embodiment, the spacers can be made adjustable, even made adjustable from the atmosphere side. 316 is a gas distribution system that is fixed between the end-block pairs.

The above described module is particularly advantageous as it makes the retrofitting of existing planar elongated target modules with the inventive rotatable target modules possible. Such a substitution was not possible in the past because the pumping for planar magnetrons was specifically adapted to planar magnetrons and was not fit for rotatable magnetrons. Additionally the installation of the inventive module liberates one pump module opening that now can be equipped with an additional sputtering module.

While the invention has been particularly shown and described with reference to this embodiment, it will be understood by those skilled in the art that various alterations and modifications in form and detail may be made therein.

## Claims

1. A sputtering module vacuum-tight mountable on an evacuable compartment of a coating line, comprising an interface flange having a vacuum side and an atmospheric side opposite to said vacuum side, at least one pair of end-blocks connectable to said vacuum side for carrying one or more sputtering targets inside said compartment
**characterised in that**
said module further comprises vacuum pumps mounted on the atmospheric side of said interface flange, said interface flange being provided with evacuation openings having a fixed spatial relationship to said targets, said pumps for evacuating said compartment through said openings.

2. The module according to claim 1, wherein said sputter targets are rotatable targets carryable by said end-blocks.

3. The module according to any one of claim 1 or 2 wherein said module further comprises a diverter carried by said vacuum side of said interface flange and situated between said openings and said targets for diverting the gas evacuation flow.

4. The module according to claim 3 wherein said diverter is adjustably mounted for adjusting the pumping rate inside said compartment, laterally along said targets.

5. The module according to claim 4 wherein said diverter is adjustable from said atmospheric side for adjusting said diverter while said compartment is evacuated.

6. The module according to any one of claim 3 to 5 further comprising a gas distribution system mounted between said diverter and said targets.

7. The module according to any one of the above claims further comprising one or more of the following means mounted on said atmospheric side of said interface flange: gas feeding means, electricity feeding means, coolant feeding means, target movement or target rotation means or control means.

8. The module according to any one of the above claims wherein said interface flange of said module lays in a substantially horizontal plane.

9. A coating line for the coating of sheet-like materials comprising one or more evacuable compartments on which the module of claim 7 or 8 is mounted.
